# EUROPEAN PATENT APPLICATION

(11) **EP 3 046 034 A1**
(43) Date of publication of application: **20.07.2016**
(21) Application number: 16157012.2
(22) Date of filing: 22.02.2013
(51) Int. Cl.: G06F 13/42, G06F 13/00

(54) **INPUT DECODER**

(30) Priority: 22.02.2012 GB 201203018
(62) Divisional of application: 13707905.9
(71) Applicant: Nordic Semiconductor ASA, 7004 Trondheim (NO)
(72) Inventor: CHETTIMADA, Vinayak Kariappa, 7004 Trondheim (NO); CUFI, Carles, 7004 Trondheim (NO); TARALDSEN, Bjørn Tore, 7004 Trondheim (NO); ENGELIEN-LOPES, David Alexandre, 7004 Trondheim (NO); FURSET, Kjartan, 7004 Trondheim (NO)
(74) Representative: Samuels, Adrian James

(57) **Abstract**

An interface controller (2) is operated to give one of a plurality of predetermined outputs. An input signal (211) is received and a duration of said input signal is compared with a first and/or second threshold duration. A first output is generated if said input signal duration is shorter than said first threshold duration. A second output is generated if said input signal duration is longer than said first threshold duration but shorter than said second threshold duration. A third output is generated if said input signal duration is longer than said second threshold duration.

## Description

This invention relates to input decoders, particularly although not exclusively for user interface devices, and to methods of operating the same to allow for control of a device.

When viewed from a first aspect the invention provides a method of operating an interface controller to give one of a plurality of predetermined outputs, the method comprising:
receiving an input signal,
comparing a duration of said input signal with a first and/or second threshold duration; and
generating a first output if said input signal duration is shorter than said first threshold duration; or
generating a second output if said input signal duration is longer than said first threshold duration but shorter than said second threshold duration; or generating a third output if said input signal duration is longer than said second threshold duration.

The invention also extends to a an interface controller configured to give one of a plurality of predetermined outputs, the interface controller comprising:
receiving means for receiving an input signal; and
processing means configured to:
   compare a duration of said input signal with a first and/or second threshold duration; and
   generate a first output if said input signal duration is shorter than said first threshold duration; or
   generate a second output if said input signal duration is longer than said first threshold duration but shorter than said second threshold duration; or
   generate a third output if said input signal duration is longer than said second threshold duration.

Thus it will be seen by those skilled in the art that in accordance with the invention an output of an interface controller can be determined simply through the duration of an input signal. This gives a very efficient and flexible control mechanism which is easy to implement.

The interface controller could be arranged to receive (e.g. from the input signal itself) a numerical value representing the duration of the input signal and to compare this value numerically to said first and/or second threshold durations at a later time (e.g. in a separate process). In preferred embodiments however the interface controller measures the duration of the input signal in real time.

The interface controller could be arranged to determine the duration of the input signal and then to compare said duration with said second threshold first. It may not be necessary to carry out both comparisons depending on the outcome of the first comparison. For example if the duration is compared with the second threshold duration first and is found to exceed it, the interface controller can give the third output without needing to compare it with the first threshold. The invention is however not limited to this and the interface controller could carry out both comparisons in all cases.

In a set of possible embodiments however the interface controller is arranged to compare the duration of the input signal to the first threshold duration first. This potentially allows the interface controller to give the first output more quickly if that is the appropriate output.

The comparison may be made in real time while the input signal is being received. This potentially allows the interface controller to give the appropriate output more quickly, particularly the third output as it may not be necessary to wait for the input signal to terminate in this case. If the input signal terminates before the first threshold duration is reached the first output can be given, if it terminates after the first threshold duration but before the second threshold duration the second output can be given and if it has not terminated after the second threshold duration the third output can be given, even if the input signal has not yet terminated. Alternatively an output is given only when the input signal has terminated, except that optionally a third threshold may be defined after which the third output is given even though the input signal may not have finished in order to avoid problems with say a stuck key.

It will be appreciated by those skilled in the art that the principle of using the duration of an input signal to determine between a plurality of possible outputs can be extended beyond three outputs to any desired number and thus when viewed from a second aspect the invention provides a method of operating a device comprising an interface controller to give one of a plurality, n, of predetermined outputs, the method comprising:
receiving an input signal,
comparing a duration of said input signal with up to n-1 threshold durations; and
generating an output dependent on which of said threshold durations said input signal duration exceeds and/or which of said threshold durations said input signal duration does not exceed.

The optional features of the first aspect of the invention are equally applicable to the second aspect.

In both aspects of the invention the input signal could be generated artificially - e.g. by another process, either internal or external; or by an environmental parameter. In a set of preferred embodiments however the input signal is generated by a user action. This could be for example the press of a button or key, the touching of a touch-screen, the hovering of a mouse or other input mechanism, the making of a sound or indeed any other form of user input.

The outputs generated by the interface controller do not need to be mutually exclusive and thus one or more outputs may be given either simultaneously or sequentially. Where, as is preferred, the threshold comparisons are made in real time, an output may be given when the duration of the input signal reaches corresponding threshold duration. Different outputs might thereby be given as the input signal continues. If an output is not finished when another output is generated the unfinished output may or may not continue. If the subsequent outputs generated are on the same output line, then the latest output will cancel any output currently active.

The interface controller may have a single input or may have multiple inputs. Where it has multiple inputs these could each be arranged to generate outputs according to the duration of their respective input signal in accordance with the invention as set out herein. The inputs and their outputs could be independent of one another but in a set of embodiments the outputs generated in respective of two or more input signals are combined to provide a final output. This allows for a multiplication in the number of final outputs dependent on the durations of the respective input signals.

In a set of embodiments an output is given whenever an input signal is detected, regardless of its duration. This could be the first output or a separate output. For example the interface controller may be arranged to give the first output as soon as an input signal is detected and to change to or add the second output if the first threshold duration is exceeded. Alternatively an output could be given indicative of an input signal being received but a separate duration-dependent output generated when the duration is determined.

In a set of embodiments the interface controller detects the beginning of the input signal and generates said first output and if the input signal continues past the first threshold duration it generates the second output and if the input signal continues past the second threshold duration it generates the third output.

The outputs could take any of a number of different forms and these need not be the same as each other for the three or more outputs. In basic embodiments the outputs, or some of them, could comprise a simple change in the logic level of an output pin (either transiently or until changed again). One or more outputs could be null - i.e. the output comprises the absence of a signal or other positive output.

However in a set of embodiments specifically envisaged herein at least one of said outputs comprises a pulse train waveform. In a subset of such embodiments at least some of the outputs comprise a pulse train waveform having at least one parameter which differs between them. A value of said at least one parameter may by determined by an input. The at least one parameter could be one selected from the group comprising an on time, off time, pulse period and duty cycle of the waveform. Other parameters could be defined and more than one parameter could be associated with the respective outputs.

In a set of embodiments said at least one parameter pertaining to the pulse train waveform or other output parameter is configurable by a user. The output pin on which an output is generated and/or how many output pins on which an output is generated may be configurable by a user. In some embodiments a value of one or more parameters can be selected from a list of pre-defined values. In some embodiments a value of one or more parameter can be defined by a user.

Similarly in a set of embodiments at least one, and preferably all, of the duration thresholds is configurable by a user.

Configurability of the input duration thresholds and/or outputs (collectively hereinafter "configuration data") allows for significant flexibility in customisation of the interface controller. In a set of embodiments the interface controller is adapted to allow a user to set one or more of said threshold durations and/or pulse train waveform parameters and thereafter to store the duration(s) and/or parameter(s) in a non-volatile memory - e.g. a one-time programmable memory. This allows for easy configuration of the mapping of various inputs to possible outputs and also the characteristics of output waveforms simply by setting configuration data. This can be done by means of an intuitive user interface - e.g. a graphical user interface or web-style interface in a preferred set of embodiments - without the developer requiring a deep-level knowledge of the operation of the device. For example, the user interface may permit a user with no knowledge of a programming language used to write the interface controller software to configure the interface controller.

The interface controller may be configurable by a user for incorporation in a non-predetermined controlled device. A non-exhaustive list of possible devices includes a media device such as a DVD player, a remote controller device such as a TV remote, a monitoring device such as a thermometer or heart rate monitor, or a wireless smartphone accessory. The controlled device may take one or more outputs from the interface controller as inputs. The controlled device may perform an action in response to one or more of said inputs. The interface controller may take an output from the controlled device as an input.

In one set of embodiments the controller enters a configuration mode if the configuration data has not been set to allow a user to enter it. Otherwise the controller uses pre-stored configuration data.

Certain embodiments of the present invention will now be described, by way of example only, with reference to the accompanying Figures in which:
Figure 1 shows a block diagram representing an exemplary device application utilizing a controller in accordance with an embodiment of the present invention;
Figure 2a shows an edge trigger event and a short press event which are registered in response to the detection of a short input pulse according to an embodiment of the present invention;
Figure 2b shows an edge trigger event and a medium press event which are registered in response to the detection of a medium input pulse according to an embodiment of the present invention;
Figure 2c shows an edge trigger event and a long press event which are registered in response to the detection of a long input pulse according to an embodiment of the present invention;
Figure 3a shows a pulse train defined by an on-state duration parameter and an off-state duration parameter in accordance with an embodiment of the present invention.
Figure 3b shows a pulse train defined by an on-state duration parameter and an off-state duration parameter, further defined by parameter indicating a number of repetitions of a period, in accordance with an embodiment of the present invention.
Figure 3c shows a pulse train defined by an on-state duration parameter; an off-state duration parameter; a parameter indicating a number of repetitions of a period; and further defined by a parameter indicating a duration after which the pulse train is repeated, in accordance with an embodiment of the present invention.
Figure 3d shows a pulse train defined by an on-state duration parameter; an off-state duration parameter; a parameter indicating a number of repetitions of a period; a parameter indicating a duration after which the pulse train is repeated; and further defined by a parameter indicating a number of repetitions of the pulse train, in accordance with an embodiment of the present invention.
Figure 4 shows a block diagram representing input and output pins provided to a device in accordance with an embodiment of the present invention.
Figure 5 shows a block diagram representing a start-up process of a device in accordance with an embodiment of the present invention.

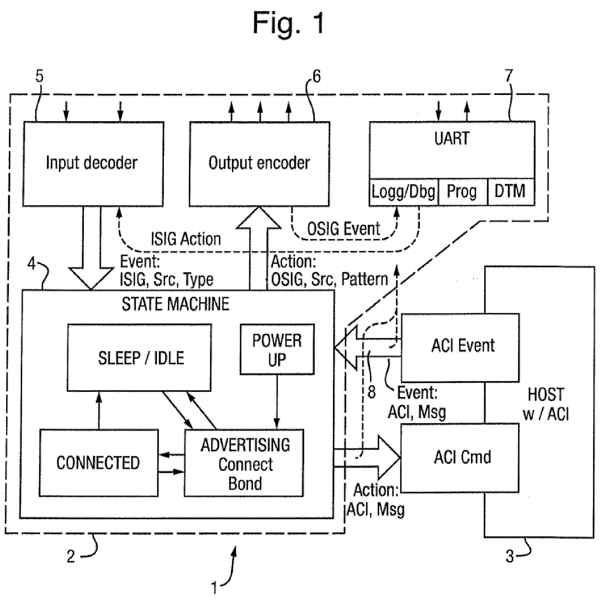

Figure 1 shows a block diagram schematically representing a *Bluetooth Low Energy* (TM) system-on-chip device 1 which incorporates an interface controller 2 embodying the present invention. The interface controller 2 is in communication with a host 3 which comprises an application control interface. The interface controller 2 includes a state machine 4, an input decoder 5, an output encoder 6 and a universal asynchronous receiver/transmitter (UART) 7. The interface controller is also provided with a non-volatile one-time programmable (OTP) memory and random access memory (RAM).

In this embodiment the interface controller 2 implements *Bluetooth Low Energy* (TM) radio communication protocols to communicate with peer devices (not shown). A peer device may be for example a remote sensor (e.g. a temperature sensor or heart rate monitor), a remote media device (e.g. a television or music player), a communication device (e.g. a mobile phone) or a PC, tablet laptop etc.

The state machine 4 receives input 8 from the host 3. The input may be instructions, for example to cause the device to connect with or disconnect from a peer device (not shown) or to enter an idle state or to transmit or receive data to or from a peer device. The input may also be data, for example sensor data (e.g. from a local battery monitor or temperature sensor). The state machine 4 can also convey output to the host 3. The output may be instructions, for example to carry out an action in response to user input decoded by the input decoder 5 (as described in more detail below). The output may also be data received

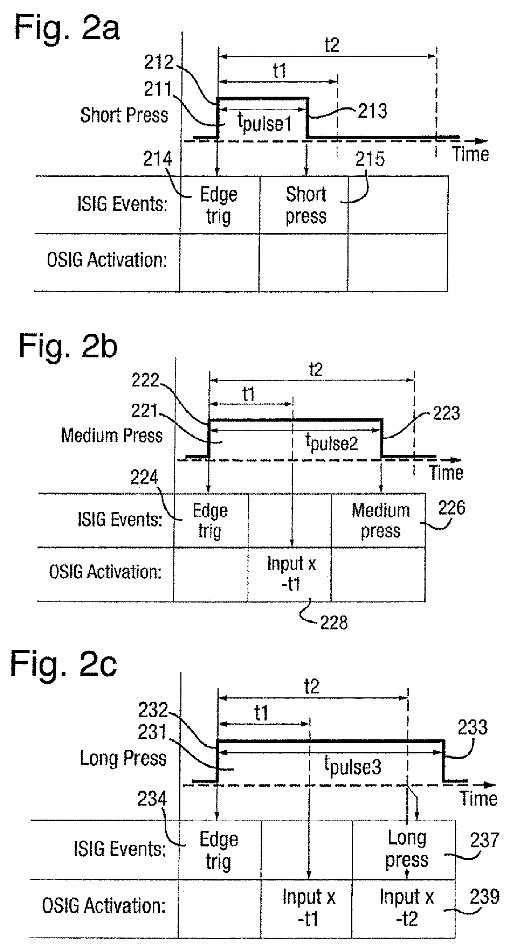

The operation of the input decoder 5 will now be described with reference to Figs 2a-2c. The input decoder 5 in this embodiment is able to identify three kinds of pulses: a short pulse 211, as shown in Fig 2a; a medium pulse 221 as shown in Fig 2b; and long pulse 231 as shown in Fig 2c.

The input decoder receives an input signal 211, 221, 231. For example the input signal may be generated by a user interaction with a button in communication with the input decoder so that the input pulse corresponds to the user pressing the button. The input signal may be any kind of analogue or digital signal, however.

Upon detection of the leading edge 212, 222, 232 (Fig 2a) of the pulse, the input decoder 5 registers an edge trigger event 214, 224, 234 and communicates to the state machine 4 a message that an edge trigger event 214, 224, 234 has been registered.

Upon detecting the trailing edge of the pulse 213, 223, 233, the input decoder compares the duration of the pulse with two threshold duration values t1 and t2 stored in the RAM. If the pulse is shorter than both t1 and t2, the input decoder 5 registers a short press event 215 and communicates to the state machine that a short press event 215 has been registered. If the pulse is longer than t1 but shorter than t2, the input decoder 5 registers a medium press event 226 and communicates to the state machine that a medium press event 226 has been registered. If the pulse is longer than both t1 and t2, the input decoder 5 registers a press event 237 and communicates to the state machine that a long press event 237 has been registered. The various events generated by the input decoder 5 are the outputs of the input decoder which are generated in dependence upon the duration of the input signal.

The state machine 4 may perform any of a number of functions and/or enter one of a number of states based on the event message it receives from the input decoder 5 - i.e. corresponding to a short, medium or long press or an edge trigger event. The action performed by the state machine or by the host depends on a mapping of the type of event (short, medium or long press or edge trigger event) to possible actions that could be carried out by the state machine 4 or the host 3. This mapping is stored in the RAM and accessed by the state machine 4 when it receives the message indicating the type of event from the input decoder 5.

For example, the state machine may initiate or terminate a connection with a peer device if a long press is detected. The state machine 4 may pass an action to the host 3 to take an action based on the whether a short, medium or long press or edge trigger event has been detected. For example, the message may instruct the host device to perform an action on the remote peer (e.g. to play a media file, to enter a low power mode, to switch off).

Additionally or alternatively the state machine 4 may pass an action to the output encoder 6 to give an output to the user as will be described below..

Referring again to Figs 2a-2c, as previously described, while the pulse is being received by the input decoder 5, the input decoder 5 detects if/when the pulse duration passes the duration t1. When the pulse passes duration t1, an output 228 is generated and a message communicating this output 228 is sent via the state machine 4 to the output encoder 6. The input decoder 5 also detects if/when the pulse duration passes the duration t2. When the pulse passes duration t2, an output 239 is generated and a message communicating this output 239 is sent via the state machine 4 to output encoder 6.

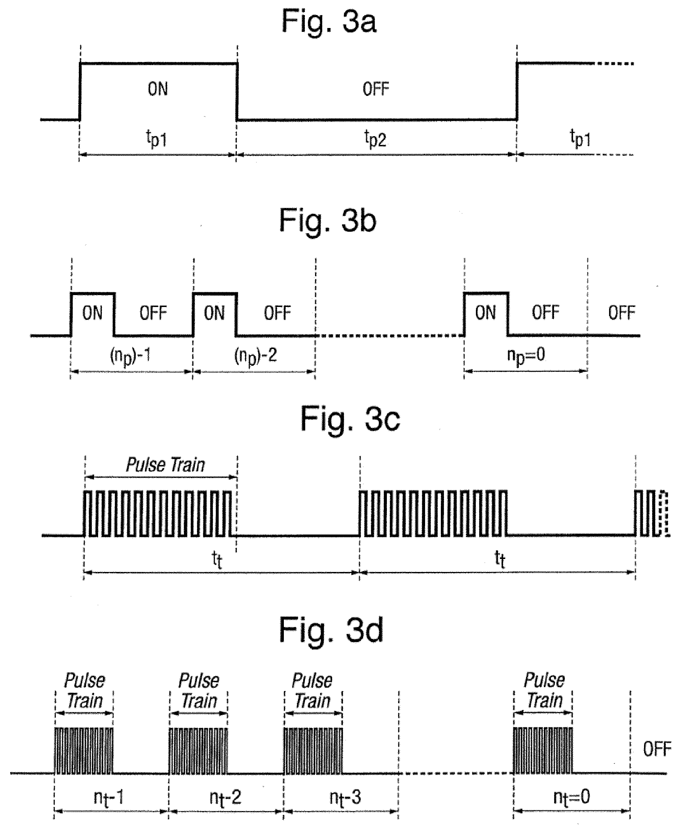

The operation of output encoder 6 is now described with reference to Figs 3a-3d. When the output decoder 6 receives a message communicating an output 228, 239, it generates an output signal on an output pin of the device. In this embodiment, the output signal is a pulse train waveform. The pulse train waveform is defined by a number of parameters, including duration of an on state tp1 and duration of an off state tp2 (see Fig. 3a), number of repetitions of the on-off period np (see Fig. 3b), time after which a pulse train should be repeated tt (see Fig 3b) and number of repetitions of a pulse train nt (see Fig 3d).

The RAM stores sets of parameters for a number of pulse train waveforms. The output decoder 6 selects a set of parameters according to which output it received from the input encoder 5, and generates a pulse train waveform according to that set of parameters on an output pin of the device. The set of parameters is selected according to a mapping of parameter sets to outputs received from the input decoder 5, which stored in the RAM.

The pulse train waveform can be used to drive an indicator device (e.g. an LED). The pulse train waveform thus provides information to the user regarding which event (short, medium or long press) has been triggered by their input to the button.

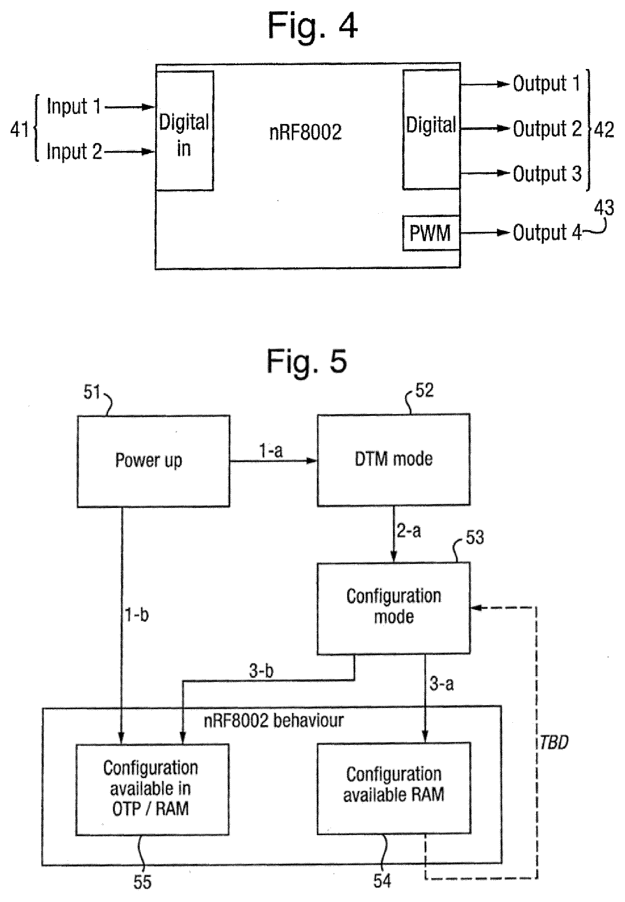

Figure 4 shows a representation of the input and output pins provided to the device in accordance with this embodiment of the invention. The device is provided with two input pins 41 for receiving input pulses. The user may provide input on either of these pins. For example, each pin may be connected to one of two buttons on an input device. The input decoder then identifies eight kinds of events: short, medium or long press or edge trigger events on the first pin, and short, medium or long press or edge trigger events on the second pin. Eight possible actions may then be performed in response to an input from a user.

The device is provided with three digital output pins 42. The output pattern may be output on any of the pins. The pin selected to receive the output may depend on which output pattern is to be output, or the pin may be selected based on other criteria or data available to the device. Different pulse train waveforms may be provided to each output pin, or two different outputs may correspond to the same pulse train waveform output to a different pin in each case. The pins may be connected to different indicator devices, e.g. different LEDs.

The device is also provided with an output pin suitable for outputting pulse-width modulated wave forms, for example for producing audio output. A pulse-width modulated waveform may be mapped to a particular output in the place of a digital output pulse train waveform parameter set as discussed above with reference to Figs. 3a-3d.

Figure 5 shows a block diagram representing the start-up process of the device and in particular indicates how the device loads or accepts as input the stored parameters t1, t2, the parameters associated with the pulse train waveforms, the mapping of events registered by the input decoder to actions performed by the state machine or passed to the host, and the mapping of output actions received by the output encoder to sets of parameters used to generate pulse train waveforms.

When the device gets powered up the behavior will depend on whether a valid configuration of the above-listed parameters is available or not (available here means whether the configuration is pre-programmed into the OTP memory or not).

PowerUp 51 is when the device is powered up for the first time (i.e. when the battery is installed) or the chip is reset. If there is no valid configuration available in the OTP memory, the device will start in a Direct Test Mode (DTM) 52. If the OTP contains valid configuration (which is copied from OTP to RAM and verified) the device is started in an operating mode 55 in which the configuration is available in OTP/RAM memory.

In DTM mode the device will initialize the DTM module and enable the UART waiting for DTM commands/Events. When the device receives a disable command/sequence on the UART the DTM gets disabled and it goes into Configuration mode 53.

Configuration mode is where the device receives the configuration generated. The configuration data have a setting indicating whether it should be stored in RAM only or if it also should be programmed into the OTP memory. This setting also defines the next mode.

If the configuration is setup to only be placed in RAM, when the configuration sequence is finished, the device enters a further operating mode 54 in which the configuration is available in RAM only.

If the configuration is setup to be programmed into the OTP memory, the device programs the configuration into the OTP memory and then enters the operating mode (5) 55. This permanently disables the DTM mode.

The operating modes 54, 55 are where the main application is started. The two operating modes 54, 55 behave the same way except that in the further operating mode 54 in which the configuration is available in RAM only we have the possibility of going back to DTM mode 52 (by resetting the chip) and entering configuration mode 53, replacing the existing configuration. When in the operating mode 55 in which the configuration is available in OTP/RAM memory, the UART 7 will be turned off.

It will be seen that the arrangement described here allows for easy configuration of the mapping of various inputs to possible outputs and also the characteristics of output waveforms simply by setting configuration data. This can be done by means of an intuitive user interface - e.g. a web-style interface without the developer requiring a deep-level knowledge of the operation of the device.

It will be appreciated by those skilled in the art that although one specific way of configuring the device has been described herein, there are many alternatives possible within the scope of the invention.

## Claims

1. A method of operating a device comprising an interface controller to give one of a plurality, n, of predetermined outputs, the method comprising:
receiving an input signal,
comparing a duration of said input signal with up to n-1 threshold durations, where n is at least 3; and
generating an output dependent on which of said threshold durations said input signal duration exceeds and/or which of said threshold durations said input signal duration does not exceed;
wherein a user configures at least one parameter pertaining to the pulse train waveform or other output parameter.

2. A method as claimed in claim 1 comprising measuring the duration of the input signal in real time.

3. A method as claimed in any preceding claim wherein the input signal is generated by a user action.

4. A method as claimed in any preceding claim wherein said interface controller has a plurality of inputs, the method comprising combining the outputs generated in respect of two or more input signals to provide a final output.

5. A method as claimed in any preceding claim comprising giving an output whenever an input signal is detected, regardless of its duration.

6. A method as claimed in any preceding claim comprising detecting the beginning of the input signal and generating the or a first output; if the input signal continues past the first threshold duration, generating the or a second output; and if the input signal continues past the or a second threshold duration, generating the or a third output.

7. A method as claimed in any preceding claim comprising a user configuring at least one, and preferably all, of the duration thresholds.

8. A method as claimed in any preceding claim comprising entering a configuration mode if configuration data has not been set to allow a user to enter it.

9. An interface controller configured to give one of a plurality, n, of predetermined outputs, the interface controller comprising
receiving means for receiving an input signal; and
processing means configured to:
compare a duration of said input signal with up to n-1 threshold durations, where n is at least 3; and
generate an output dependent on which of said threshold durations said input signal duration exceeds and/or which of said threshold durations said input signal duration does not exceed;
the controller further comprising means for allowing a user to configure at least one parameter pertaining to the pulse train waveform or other output parameter.

10. A controller as claimed in claim 9 arranged to measure the duration of the input signal in real time.

11. A controller as claimed in any of claims 9 or 10 wherein the input signal is generated by a user action.

12. A controller as claimed in any of claims 9 to 11 wherein said interface controller has a plurality of inputs and is arranged to combine the outputs generated in respect of two or more input signals to provide a final output.

13. A controller as claimed in any of claims 9 to 12 arranged to give an output whenever an input signal is detected, regardless of its duration.

14. A controller as claimed in any of claims 9 to 13 arranged to detect the beginning of the input signal and generate the or a first output, and if the input signal continues past the or a first threshold duration to generate the or a second output and if the input signal continues past the second threshold duration to generate the or a third output.

15. A controller as claimed in any of claims 9 to 14 comprising means for allowing a user to configure at least one, and preferably all, of the duration thresholds.

16. A controller as claimed in any of claims 9 to 15 arranged to enter a configuration mode if configuration data has not been set to allow a user to enter it.
